# EUROPÄISCHE PATENTANMELDUNG

(11) **EP 3 993 180 A1**
(43) Veröffentlichungstag der Anmeldung: **04.05.2022**
(21) Anmeldenummer: 21205234.4
(22) Anmeldetag: 28.10.2021
(51) Int. Cl.: H01R 13/719, H01R 13/66, H01R 12/71, H01R 13/648

(54) **KONTAKTPINSTECKER, KONTAKTPINSTECKERSYSTEM UND VERFAHREN**

(30) Priorität: 29.10.2020 DE 102020213608
(71) Anmelder: Yamaichi Electronics Deutschland GmbH, 85609 Aschheim-Dornach (DE)
(72) Erfinder: Quiter, Michael, 57482 Wenden (DE); Michel, Dirk, 85778 Haimhausen (DE)
(74) Vertreter: Müller-Boré & Partner Patentanwälte PartG mbB

(57) **Zusammenfassung**

Ein Kontaktpinstecker (100; 101) weist ein Gehäuse (110, 130) und eine Mehrzahl von Kontaktpins (140) auf, welche an dem Gehäuse (110, 130) so ausgebildet und angeordnet sind, dass sie zum Kontaktieren und Verlöten mit einer Leiterplatte von dem Gehäuse (110, 130) abstehen. Dabei sind zumindest einige der Kontaktpins (140) elektrisch gekoppelt an jeweils zugehörige elektrische Bauteile (170) zum Filtern und/oder Entstören von elektrischen Signalen, welche entlang der jeweils zugehörigen Kontaktpins (140) übertragen werden. Diese elektrischen Bauteile (170) sind mittels Reflow-Verfahren auf eine Platine (160) des Kontaktpinsteckers (100; 101) aufgelötet sind, welche auch die Kontaktpins (140) elektrisch kontaktieren.

## Beschreibung

Die Erfindung betrifft einen Kontaktpinstecker, ein Kontaktpinsteckersystem und ein Verfahren zur Herstellung eines Kontaktpinsteckers.

Kontaktpinstecker können als Anschlusskästen ausgebildet sein und eine Mehrzahl von Kontaktpins aufweisen, die mit einer Leiterplatte verlötet sind. Kontaktpinstecker können z.B. als ein MQS-Stecker ausgebildet sein, wobei MQS für "Micro-Quadlock System" steht, und/oder als ein Automobilstecker. Kontaktpinstecker sind eine bestimmte Art von Steckern mit einer Vielzahl von elektrischen Kontakten. Kontaktpinstecker zeichnen sich durch eine hohe Widerstandsfähigkeit bei mechanischen Belastungen aus, wie sie insbesondere bei Automobilen auftreten können.

Kontaktpinstecker können z.B. wasserdicht und relativ kompakt gebaut sein. Deswegen werden Kontaktpinstecker vornehmlich im Automobilbereich verwendet, und zwar als Anschlusskästen für Autoradios, Autonavigationssystem, etc.

Kontaktpinstecker werden üblicherweise mittels Durchsteckmontage (auf Englisch: Through Hole Technology, abgekürzt als THT) elektrisch mit Leiterplatten kontaktiert.

Der Erfindung liegt die Aufgabe zugrunde, einen kompakten Kontaktpinstecker der eingangs benannten Art mit verbesserter Übertragungsqualität bereitzustellen.

Diese Aufgabe wird durch die Gegenstände der unabhängigen Ansprüche gelöst. Bevorzugte Ausführungsformen sind die Gegenstände der abhängigen Ansprüche.

Ein Aspekt betrifft einen Kontaktpinstecker mit einem Gehäuse und einer Mehrzahl von Kontaktpins, welche an dem Gehäuse so ausgebildet und angeordnet sind, dass sie zum Kontaktieren und Verlöten mit einer Leiterplatte von dem Gehäuse abstehen. Dabei sind zumindest einige der Kontaktpins elektrisch gekoppelt an jeweils zugehörige elektrische Bauteile zum Filtern und/oder Entstören von elektrischen Signalen, welche entlang der jeweils zugehörigen Kontaktpins übertragen werden. Diese elektrischen Bauteile sind zum Filtern und/oder Entstören mittels Reflow-Verfahren auf den Kontaktpinstecker aufgelötet und/oder auflötbar.

Bei dem Kontaktpinstecker kann es sich um einen Kontaktpinstecker der eingangs genannten Art handeln. Der Kontaktpinstecker ist dazu ausgebildet und vorgesehen, in Kontaktrichtung zu der Leiterplatte hin bewegt zu werden, und zwar mit den aus dem Kontaktpinstecker herausragenden Kontaktpins zuerst. Die Kontaktpins können in physikalischem Kontakt mit der Leiterplatte mit dieser verlötet werden. Hierbei kann die Kontaktrichtung vom Kontaktpinstecker weg etwa im Lot auf eine dem Kontaktpinstecker zugewandte flächige Seite der Leiterplatte weisen.

Der Kontaktpinstecker kann als "Mehrzahl von Kontaktpins" zumindest 10 Kontaktpins aufweisen, bevorzugt zumindest 20 Kontaktpins, besonders bevorzugt zumindest 40 Kontaktpins. Alle diese Kontaktpins weisen zumindest mit einem Ende aus dem Kontaktpinstecker heraus, insbesondere im Wesentlichen in Kontaktrichtung.

Zumindest eine Mehrzahl der Kontaktpins, in einer Ausführungsform alle Kontaktpins und/oder zumindest Kontaktpinpaare, sind elektrisch gekoppelt an jeweils zugehörige elektrische Bauteile zum Filtern und/oder Entstören der über die Kontaktpins übertragenen elektrischen Signale. Bei diesen elektrischen Bauteilen kann es sich um passive oder aktive Bauteile handeln.

Passive Bauteile können den Vorteil haben, dass sie üblicherweise weniger Bauteilaufwand benötigen, kostengünstiger sind und/oder keine Steuerung benötigen. Beispielsweise kann ein passives Bauteil durch einen (z.B. einzigen) Kondensator bereitgestellt werden.

Aktive Bauteile können den Vorteil haben, genauer einstellbar zu sein und/oder ihre Filterwirkung abhängig von der jeweiligen Anwendung variieren zu können. Weiterhin kann die Filterwirkung aktiver Bauteile ggf. ganz ausgeschaltet und/oder verstärkt werden.

Allgemein sind die elektrischen Bauteile dazu ausgebildet und vorgesehen, unerwünschte Frequenzen aus den jeweils übertragenen Signalen herauszufiltern. Dabei kann es sich um Störfrequenzen handeln, die die Signalqualität mindern. Deswegen dienen die elektrischen Bauteile zum Filtern und/oder Dämpfen der durch den Kontaktpinstecker übertragenen elektrischen Signale.

Die elektrischen Bauteile zum Filtern und/oder Entstören und/oder Dämpfen sind derart ausgebildet, dass sie durch eine Oberflächenmontage und/oder Through-Hole-Reflow-Technologie am Kontaktpinstecker befestigt sind oder befestigt werden können. Hierbei kann insbesondere das Material der elektrischen Bauteile und/oder ihre Ausbildungsform durch diese Eigenschaft bedingt sein. Genauso ist auch der Kontaktpinstecker so ausgebildet, dass die elektrischen Bauteile zum Filtern und/oder Entstören durch eine Oberflächenmontage und/oder Through-Hole-Reflow-Technologie an ihm befestigbar sind. Die elektrischen Bauteile zum Filtern und/oder Entstören bilden dabei einen Bestandteil des Kontaktpinsteckers aus.

Beispielsweise kann der Kontaktpinstecker selber als ein oberflächenmontiertes Bauelement ausgebildet sein, was auf Englisch mit dem Begriff "surface mount device" bezeichnet wird, was auch mit SMD abgekürzt wird. Der Kontaktpinstecker kann auch als ein THR-Bautelement ausgebildet sein, wobei THR als Abkürzung für Through-Hole-Reflow-Technologie steht.

Im Gegensatz zu herkömmlichen THT Kontaktpinsteckern kann der ganze erfindungsgemäße Kontaktpinstecker als ein SMD- und/oder THR-Bauelement ausgebildet sein. Als solches SMD weist der Kontaktpinstecker keine langen Drahtanschlüsse auf, sondern lotfähige Anschlussflächen, die von den aus dem Gehäuse herausstehenden Kontaktpins bereitgestellt werden. Diese Art der Kontaktierung wird auch mit SMT bezeichnet, welches eine Abkürzung für den englischen Begriff "surface mounted technology" darstellt.

Mittels der THR-Technologie können Steckverbinder, die eigentlich nicht für die SMD-Bauweise geeignet sind, trotzdem dem Reflow-Lötverfahren zugänglich zu machen. In diesem Zusammenhang wurde die Through-Hole-Reflow-Technologie entwickelt. Dabei werden Through-hole-Bauelemente für die automatische Bestückung und die hohe thermische Belastung im Reflow-Ofen konstruiert. So lassen sich die Bestückungskosten für die automatische Leiterplattenbestückung senken, da einige Prozessschritte der normalen THT-Bestückung entfallen.

Bevorzugt ist der Kontaktpinstecker als ein THR-Bauelement ausgebildet.

Die Kontaktierung zwischen den elektrischen Bauteilen und dem Kontaktpinstecker kann in einem Weichlötverfahren erfolgen und/oder erfolgt sein, z.B. im sogenannten Reflow-Verfahren. Dabei werden die elektrischen Bauteile zusammen mit dem Kontaktpinstecker, ggf. sogar gleich zusammen mit der Leiterplatte, in einen Ofen eingebracht, in welchem die elektrischen Bauteile mitsamt dem Kontaktpinstecker und ggf. der Leiterplatte so erhitzt werden, dass vorbestimmte Lötverbindung zwischen den genannten Elementen hergestellt werden.

Die elektrischen Bauteile sind entweder bereits mit dem Kontaktpinstecker durch ein Reflow-Verfahren verlötet, oder sie sind noch nicht verlötet, sondern lediglich vorbefestigt und werden erst beim Anschließen des Kontaktpinstecker an die Leiterplatte im Reflow-Ofen am Kontaktpinstecker befestigt.

Durch das Vorsehen der elektrischen Bauteile unmittelbar auf dem Kontaktpinstecker kann eine besonders platzsparende und zudem unmittelbar wirksame Entstörung und/oder Filterung der übertragenen Signale erreicht werden. Dies verbessert die Übertragungsqualität des Kontaktpinsteckers. Die Übertragungsqualität kann dabei z.B. so sehr gesteigert werden, dass auf eine zusätzliche Entstörung am Kabelbaum des Automobils verzichtet werden kann. Alternativ kann eine Entstörung am Kabelbaum durch die elektrischen Bauteile ergänzt und somit verstärkt und/oder verbessert werden.

Dadurch wird ein Reflow-fähiger Kontaktpinstecker mit verbesserter Singalübertragungsqualität bereitgestellt.

Gemäß einer Ausführungsform sind die elektrischen Bauteile auf eine Platine des Kontaktpinsteckers aufgelötet und/oder auflötbar, welche auch die Kontaktpins elektrisch kontaktieren. Beispielsweise können die Kontaktpins mit der Platine verlötet sein, so dass sie die elektrischen Bauteile über die Platine kontaktieren. Der Kontaktpinstecker kann die Platine als integraler Bestandteil aufweisen. Auf die Platine sind die elektrischen Bauteile mittels Reflow-Verfahren aufgelötet und/oder auflötbar, in einer Ausführungsform z.B. genauso wie auch die Kontaktpins. Die Platine kann z.B. als ein PCB ausgebildet sein.

In einer Weiterbildung dieser Ausführungsform weist der Kontaktpinstecker elektrische Steckkontakte auf, welche mit den Kontaktpins über die Platine elektrisch kontaktiert sind. Dabei sind die elektrischen Bauteile jeweils benachbart zu den elektrischen Steckkontakten auf der Platine angeordnet. Die Steckkontakte können z.B. an einer Steckseite des Kontaktpinsteckers ausgebildet sein, an welcher sie einen elektrischen Steckverbinder kontaktieren können. Elektrische Signale können von diesem Steckverbinder über die Steckkontakte und die Platine an die Kontaktpins übertragen werden und von dort auf die Leiterplatte. Auf der Platine sind auch die elektrischen Bauteile zum Filtern und/oder Entstören angeordnet.

Gemäß einer Ausführungsform weisen die elektrischen Bauteile einen Kondensator auf und/oder sie sind als Kondensatoren ausgebildet. Kondensatoren eignen sich als passive Bauteile zum Entstören und/oder Dämpfen von Signalen. Hierbei kann jedem Kontaktpinstecker und/oder Kontaktpinsteckerpaar ein dedizierter Kondensator zugeordnet sein, der mit dem Kontaktpinstecker elektrisch verbunden ist. Die Kondensatoren sind auf den Kontaktpinstecker mittels Reflow-Verfahren aufgelötet und/oder auflötbar.

Gemäß einem Ausführungsbeispiel sind zur Signalübertragung ausgebildete Kontaktpins mit elektrischen Bauteilen kontaktiert, welche zumindest einen Kondensator im Nanofarad-Bereich aufweisen. Der Kondensator im Nanofarad-Bereich weist eine Kapazität von etwa 1nF bis etwa 999nF auf und ist zum Dämpfen hoher Signalfrequenzen ausgebildet. Diese Kontaktpins aus der Menge der Kontaktpins sind somit als Singalübertragungskontaktpins ausgebildet. Sie können z.B. zur Übertragung von Lautsprechersignalen ausgebildet und/oder angeschlossen sein, also z.B. als Audiosignalübertragungskontaktpins. Dabei dienen die Kondensatoren im Nanofarad-Bereich zum Herausfiltern hoher Signalfrequenzen und somit zum Entstören des übertragenen (z.B. Audio-)Signals.

Gemäß einer Ausführungsform sind zur Stromübertragung ausgebildete Kontaktpins mit elektrischen Bauteilen kontaktiert, welche zumindest einen Kondensator im Mikrofarad-Bereich aufweisen. Dieser Kondensator im Mikrofarad-Bereich weist eine Kapazität von etwa 1µF bis etwa 999µF auf und ist zum Herausfiltern von Störsignalen aus einer Gleichstromversorgung ausgebildet. Diese Kontaktpins aus der Menge der Kontaktpins sind somit als Leistungskontaktpins zur Stromübertragung ausgebildet und/oder angeschlossen. Dabei dienen die Kondensatoren im Mikrofarad-Bereich zum breiten Entstören möglichst vieler Störfrequenzen an den Leistungsübertragungskanälen.

Gemäß einer Ausführungsform weist der Kontaktpinstecker elektrische Steckkontakte auf. Die elektrischen Signale, welche von den elektrischen Bauteilen gefiltert und/oder entstört werden, werden zwischen den elektrischen Steckkontakten und den Kontaktpins übertragen. Dabei kann jedem der Kontaktpins genau ein elektrischer Steckkontakt zugeordnet sein und die Übertragung der elektrischen Signale zwischen diesen einander zugeordneten Bauteilen erfolgen. Die elektrischen Signale können entlang einer Platine übertragen werden, welche sowohl von den Kontaktpins als auch von den elektrischen Steckkontakten elektrisch kontaktiert sind.

Die elektrischen Bauteile zum Filtern und/oder Entstören können elektrisch zwischen die Kontaktpins und die elektrischen Steckkontakte geschaltet sein.

In einer Weiterbildung dieser Ausführungsform stellt zumindest ein elektrisches Bauelement eine galvanische Trennung zwischen zumindest einem der Kontaktpinstecker und dem zugeordneten elektrischen Steckkontakt bereit. Bevorzugt ist eine Mehrzahl und/oder sind sogar sämtliche Kontaktpinstecker galvanisch vom jeweils zugeordneten elektrischen Steckkontakt getrennt und/oder entkoppelt. Hierbei ist die elektrische Leitung zwischen den zugeordneten Bauteilen durch zumindest ein elektrisch nicht leitfähiges Kopplungsglied aufgetrennt. Dadurch sind die elektrischen Potentiale an dieser Stelle voneinander getrennt und die Stromkreise sind zueinander potentialfrei. Dabei kann Gleichstrom oder ein Strom mit niedriger Frequenz nicht mehr vom elektrischen Steckkontakt zum zugeordneten Kontaktpinstecker fließen, während Wechselstromsignale gut übertragen werden. Die galvanische Trennung kann mittels Bauelementen wie Transformatoren, Optokoppler, Lichtwellenleiter und/oder Relais realisiert sein. Dabei kann die Kopplung durch Induktion, Influenz, Strahlung und/oder mittels eines potentialfreien Kontaktes realisiert sein. Beispielsweise kann zur Bereitstellung der galvanischen Trennung jeweils ein Paar von Transformatoren elektrisch zwischen den Kontaktpinstecker und den zugeordneten elektrischen Steckkontakt geschalten sein. Der Kontaktpinstecker kann die Bauelemente zur galvanischen Trennung zusätzlich zu den voranstehend beschriebenen Kondensatoren zum Filtern und/oder Entstören aufweisen.

Gemäß einer Ausführungsform weist der Kontaktpinstecker zumindest ein Bauelement auf, welches einen Schutz gegen elektrostatische Entladungen bereitstellt. Als elektrostatische Entladungen werden durch Potentialdifferenzen entstehende Spannungsdurchschläge bezeichnet, welche einen kurzen, hohen elektrischen Strom bewirken können, welcher zu Brand- und Explosionsgefährdungen führen kann. Elektrostatische Entladungen können Personen gefährden und/oder elektrische Komponenten beschädigen und werden mithilfe des zumindest einen Bauelements vermieden oder reduziert. Das Bauelement kann als ein ESD-Schutzmittel ausgebildet sein, also als ein *"electrostatic* discharge"-Schutzmittel. Das ESD-Schutzmittel kann z.B. als zumindest eine Diode ausgebildet sein, insbesondere als eine Suppressordiode, welche auch als TVS Diode bezeichnet wird, wobei TVS für *"Transient Voltage Suppressor"* steht. Das oder die ESD-Schutzmittel kann oder können dabei auf einer Platine des Kontaktpinsteckers angeordnet sein. Der Kontaktpinstecker kann das zumindest eine ESD-Schutzmittel zusätzlich zu den voranstehend beschriebenen Bauelementen zur galvanischen Trennung und/oder zusätzlich zu den Kondensatoren zum Filtern und/oder Entstören aufweisen.

Gemäß einer Ausführungsform ist der Kontaktpinstecker so ausgebildet, dass er über die Kontaktpins mittels Oberflächenmontage und/oder mittels Through-Hole-Reflow-Technologie an der Leiterplatte befestigbar ist. Hierbei sind die Kontaktpins so ausgebildet, dass der gesamte Kontaktpinstecker mittels Oberflächenmontage und/oder mittels Through-Hole-Reflow Technologie an der Leiterplatte befestigbar ist. Weiterhin kann das Gehäuse zumindest teilweise aus Flüssigkristallpolymer und/oder aus semi-aromatischen Polyamiden ausgebildet. Hierbei kann der gesamte Kontaktpinstecker reflow-fähig sein, d.h. mittels des Reflow-Verfahrens montierbar sein. Dazu kann der Kontaktpinstecker, insbeondere sein Gehäuse, Verstärkungsrippen oder ähnliches aufweisen, um den Kontaktpinstecker widerstandsfähig genug zu machen.

Gemäß einer Ausführungsform ist der Kontaktpinstecker als ein Automobilstecker und/oder als ein Micro-Quadlock System-Stecker ausgebildet. Als solcher MQS-Stecker kann er zur Anwendung als Automobilstecker ausgebildet sein, z.B. zur Leistungsübertragung und/oder zur Signalübertragung, beispielsweise für Audiosignale.

Gemäß einer Ausführungsform ist das Gehäuse zumindest teilweise aus Flüssigkristallpolymer und/oder aus semi-aromatischen Polyamiden ausgebildet.

Herkömmlich wird das Gehäuse von Kontaktpinsteckern aus PBT hergestellt, also aus Polybutylenterephthalat. Dieses Material ist jedoch nicht temperaturbeständig genug, um dem oben beschriebenen Weichlötverfahren in hinreichender Qualität standzuhalten.

Das Gehäuse des Kontaktpinsteckers kann zumindest teilweise, bevorzugt vollständig, aus einem Flüssigkristallpolymer und/oder aus semi-aromatischen Polyamiden hergestellt sein. Flüssigkristallpolymere werden auch mit der Abkürzung FKP bezeichnet, oder auf Englisch mit dem Begriff "liquid crystal polymer", welcher mit LCP abgekürzt wird. Semi-aromatische Polyamide werden mit der Abkürzung PPA bezeichnet und/oder als Polyphthalamide. Die vorgeschlagenen Materialien LCP und PPA weisen eine höhere Temperaturbeständigkeit auf als PBT.

Allerdings weisen dafür Flüssigkristallpolymere generell eine geringere Eigenfestigkeit auf. Mit anderen Worten sind Flüssigkristallpolymere und semi-aromatische Polyamide zwar temperaturbeständiger als PBT (zumindest im allgemeinen), jedoch können sie eine geringere Eigenfestigkeit aufweisen bzw. leichter spröde werden. Deswegen werden diese Materialien herkömmlich nicht für Kontaktpinstecker verwendet. Es hat sich nun allerdings herausgestellt, dass aus den Materialien dennoch ein Kontaktpinstecker hergestellt werden kann, welcher als SMD- und/oder THR-Bauteil ausgebildet ist.

Dadurch wird ein Kontaktpinstecker ermöglicht, der als ein SMD- und/oder als ein THR-Bauteil ausgebildet ist und eine hinreichende Qualität aufweist. Hierbei kann das Gehäuse kostengünstig z.B. als Spritzgussbauteil ausgebildet werden.

Das Gehäuse kann aus genau einem Material bestehen, also z.B. aus Flüssigkristallpolymer oder aus semi-aromatischen Polyamiden, oder aber aus einer Mischung dieser Materialien ausgebildet sein. Insbesondere kann das Gehäuse vollständig aus zumindest einem der genannten Materialien ausgebildet sein.

Gemäß einer Ausführungsform weist das Gehäuse zumindest eine Versteifungsrippe auf. Hierbei kann die Versteifungsrippe aus demselben Material ausgebildet sein wie das Gehäuse selber. Die Versteifungsrippe kann hierbei insbesondere einteilig mit dem Gehäuse, also z.B. als ein integriertes Gehäusebauteil, ausgebildet sein. Die Versteifungsrippe kann insbesondere zusammen mit dem Gehäuse als ein Spritzgussteil ausgebildet sein. Die Versteifungsrippe kann z.B. eine längliche Form ausweisen und zumindest teilweise entlang einer Oberfläche des Gehäuses verlaufen. Durch die Versteifungsrippe kann die Eigenfestigkeit des Gehäuses erhöht werden. Dies ist insbesondere bei den für das Gehäuse verwendeten Materialien von Vorteil.

Ein Aspekt betrifft ein Kontaktpinsteckersystem mit einem Kontaktpinstecker nach dem vorangegangenen Aspekt und einer Leiterplatte. Dabei sind die elektrischen Bauteile zum Filtern und/oder Entstören mittels Reflow-Verfahren auf den Kontaktpinstecker aufgelötet. Der Kontaktpinstecker ist über seine Kontaktpins mittels Oberflächenmontage und/oder mittels Through-Hole-Reflow¬Technologie an der Leiterplatte befestigt. Die Befestigung der elektrischen Bauteile am Kontaktpinstecker und die Befestigung der Kontaktpins auf der Leiterplatte kann im selben Reflow-Verfahren erfolgt sein, oder aber in zwei getrennten Verfahren.

Ein Aspekt betrifft ein Verfahren zum Herstellen eines Kontaktpinsteckers mit den Schritten:
- Bereitstellen eines Gehäuses des Kontaktpinsteckers;
- Bereitstellen einer Mehrzahl von Kontaktpins des Kontaktpinsteckers, welche an dem Gehäuse so ausgebildet und angeordnet werden, dass sie zum Kontaktieren und Verlöten mit einer Leiterplatte von dem Gehäuse abstehen;
- elektrisches Koppeln zumindest einiger der Kontaktpins an jeweils zugehörige elektrische Bauteile zum Filtern und/oder Entstören von elektrischen Signalen, welche entlang der jeweils zugehörigen Kontaktpins übertragen werden und
- Auflöten dieser elektrischen Bauteile zum Filtern und/oder Entstören mittels Reflow-Verfahren auf den Kontaktpinstecker.

Das Verfahren kann zum Herstellen eines Kontaktpinsteckers nach dem obigen Aspekt genutzt werden. Deswegen betreffen sämtliche Ausführungen zu dem Kontaktpinstecker auch das Verfahren und umgekehrt.

Im Rahmen dieser Erfindung können die Begriffe "im Wesentlichen" und/oder "etwa" so verwendet sein, dass sie eine Abweichung von bis zu 5% von einem auf den Begriff folgenden Zahlenwert beinhalten, eine Abweichung von bis zu 5° von einer auf den Begriff folgenden Richtung und/oder von einem auf den Begriff folgenden Winkel.

Begriffe wie oben, unten, oberhalb, unterhalb, lateral, usw. beziehen sich - sofern nicht anders spezifiziert - auf das Bezugssystem der Erde in einer Betriebsposition des Gegenstands der Erfindung.

Die Erfindung wird nachfolgend anhand von in Figuren gezeigten Ausführungsformen näher beschrieben. Hierbei können gleiche oder ähnliche Bezugszeichen gleiche oder ähnliche Merkmale der Ausführungsformen kennzeichnen. Einzelne, in den Figuren gezeigte Merkmale können mit anderen Ausführungsformen kombiniert werden. Es zeigen:
- Figur 1A: eine perspektivische Darstellung eines Kontaktpinsteckers;
- Figur 1B: eine perspektivische Darstellung eines Kontaktpinsteckers ohne Schutzkappe;
- Figur 1C: eine perspektivische Darstellung eines Gehäuseelements eines Kontaktpinsteckers;
- Figur 2A: eine perspektivische Darstellung einer Einsteckseite eines Kontaktpinsteckers;
- Figur 2B: eine perspektivische Darstellung einer Einsteckseite eines Gehäuseelements eines Kontaktpinsteckers;
- Figur 3: eine Ansicht einer Einsteckseite eines Kontaktpinsteckers in Einsteckrichtung;
- Figur 4A: eine perspektivische Darstellung eines Kontaktpinsteckers ohne Schutzkappe;
- Figur 4B: eine perspektivische Darstellung eines Gehäuseelements eines Kontaktpinsteckers;
- Figur 5: eine Ansicht eines kappenlosen Kontaktpinsteckers entgegen der Einsteckrichtung auf eine Platine des Kontaktpinsteckers, und
- Figur 6: einen Querschnitt durch einen Kontaktpinstecker.

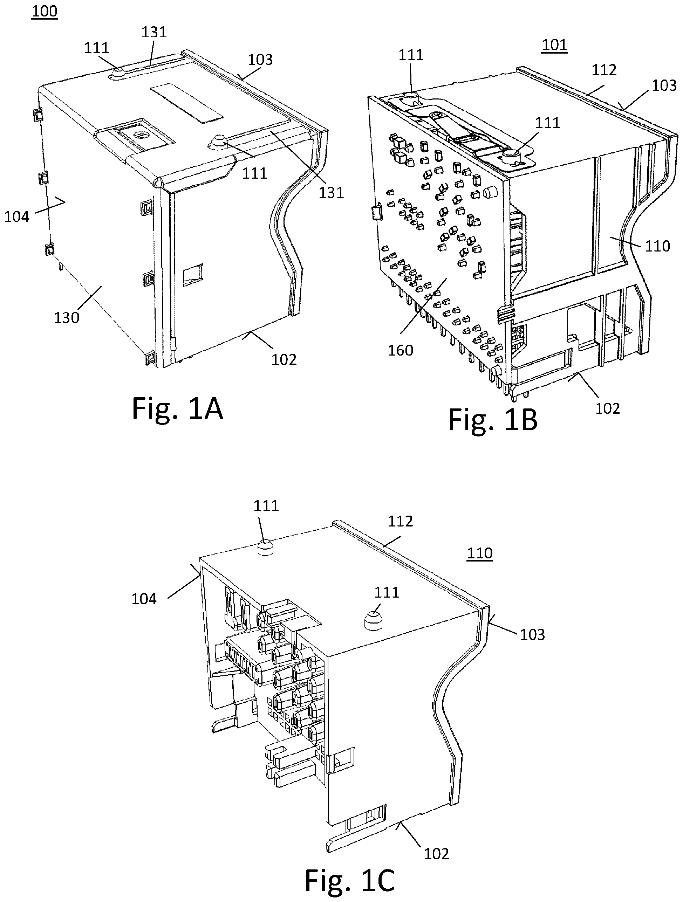

**Figur 1A** zeigt eine perspektivische Darstellung eines Kontaktpinsteckers 100. Der Kontaktpinstecker 100 weist ein mehrteiliges Gehäuse auf und ist als ein Anschlusskasten ausgebildet. Der Kontaktpinstecker ist im Wesentlichen quaderförmig ausgebildet und weist daher sechs Seitenflächen auf. Eine dieser Seitenflächen ist als eine zumindest teilweise offene Steckseite 103 ausgebildet, an der zumindest ein Steckverbinder in den Kontaktpinstecker 100 eingesteckt werden kann. Hierbei können elektrische Kontakte zwischen einem solchen (in den Figuren nicht dargestellten) Steckverbinder und dem Kontaktpinstecker 100 hergestellt werden. Eine (zumindest im gezeigten Ausführungsbeispiel) zu der Steckseite 103 benachbarte Seitenfläche des Kontaktpinsteckers 100 ist als Kontaktseite 102 ausgebildet. In der in Figur 1A gezeigten Ansicht ist die Kontaktseite 102 als Unterseite angeordnet. An der Kontaktseite 102 stehen mehrere Kontaktpins aus dem Kontaktpinstecker 100 heraus. Mittels dieser Kontaktpins kann der Kontaktpinstecker 100 mit einer Leiterplatte verbunden werden, insbesondere in einem Reflow-Weichlötverfahren, also z.B. mittels SMT- und/oder THR-Technologie.

Die Seitenfläche des Kontaktpinsteckers 100, welche der Steckseite 103 gegenüberliegend angeordnet ist, ist als eine Gegenseite 104 ausgebildet. Das Gehäuse des Kontaktpinsteckers 100 weist eine Schutzkappe 130 auf, welche so auf die Gegenseite 104 des Kontaktpinsteckers 100 gesteckt ist, dass die Schutzkappe 130 eine an dieser Gegenseite 104 ausgebildete Platine 160 überdeckt (vgl. Fig. 1B).

**Figur 1B** zeigt eine andere, aber ähnliche Ausführungsform des Kontaktpinsteckers 100 ohne die noch in Fig. 1A gezeigte Schutzkappe 130 als einen kappenlosen Kontaktpinstecker 101. Der kappenlose Kontaktpinstecker 101 weist die Bauteile auf, die auch der in Figur 1A gezeigte Kontaktpinstecker 100 aufweist, allerdings ohne die Schutzkappe 130. Die Schutzkappe 130 kann als Teil des Gehäuses des Kontaktpinsteckers 100 ausgebildet sein. Das Gehäuse des Kontaktpinsteckers 100 weist weiterhin ein Gehäuseelement 110 auf. Dieses Gehäuseelement 110 ist an der Steckseite 103 offen ausgebildet.

Der Kontaktpinstecker 100 kann ein mehrteiliges Gehäuse aufweisen, dass z.B. das Gehäuseelement 110 und die Schutzkappe 130 umfasst, insbesondere aus diesen besteht.

Die in Fig. 1B gezeigte Ausführungsform unterscheidet sich von der in den Figuren 1A und 1C gezeigten Ausführungsform unter anderem durch die Anzahl Versteifungsrippen am Gehäuseelement 110.

**Figur 1C** zeigt in einer perspektivischen Darstellung ein Ausführungsbeispiel eines Gehäuseelements 110 ohne die restlichen Elemente des Kontaktpinsteckers 100. Die Figuren 1A, 1B und 1C sind in etwa aus der gleichen Perspektive dargestellt. An der Steckseite 103 weist das Gehäuseelement 110 (in jeder der gezeigten Ausführungsformen) zumindest eine Versteifungsrippe 112 auf. Diese Versteifungsrippe 112 ist als eine Verdickung derjenigen Endkante ausgebildet, welche an der Steckseite 103 ausgebildet ist. Die Versteifungsrippe 112 umläuft das Gehäuseelement 110 vollständig entlang des Randes, also entlang der Endkante, welche unmittelbar an der Steckseite 103 ausgebildet ist. Die Versteifungsrippe 112 ist in sich geschlossen. Die Versteifungsrippe 112 ist an der nach außen gewandten Seitenfläche des Gehäuseelements 110 ausgebildet und verdoppelt die Wandstärke des Gehäuseelements 110 zumindest. Die Versteifungsrippe 112 könnte in einem Ausführungsbeispiel auch noch breiter als eine mittlere Wandstärke des Gehäuses, insbesondere des Gehäuseelements 110, ausgebildet sein.

Durch die Versteifungsrippe 112 wird die Stabilität des Gehäuseelements 110 erhöht, und damit auch die Stabilität des Gehäuses des Kontaktpinsteckers 100 insgesamt. Dies ermöglicht die Verwendung von Materialien für das Gehäuseelement 110, die eine geringere Eigensteifigkeit als z.B. PBT aufweisen. Somit kann das Gehäuseelement 110 z.B. aus LCP oder aus einem PPA ausgebildet sein, insbesondere aus PA9T und/oder PA10T. Diese Materialien weisen eine höhere Temperaturbeständigkeit auf als PBT, weswegen das Gehäuseelement 110 auch im Rahmen eines Weichlötverfahrens wie z.B. eines Reflow-Verfahrens in einem entsprechenden Heizofen eingebracht werden kann, ohne sich hierbei zu stark zu verformen. Solche Weichlötprozesse werden in der SMT- und/oder in der THR-Technologie verwendet.

Der Kontaktpinstecker 100 ist als ein oberflächenmontiertes Bauelement ausgebildet, auch genannt SMD (surface mounted device), und/oder als ein THR-Bauelement, also als ein Through-Hole-Reflow-Technologie Bauelement.

An der Gegenseite 104 ist die Platine 160 so angeordnet, dass sie den kappenlosen Kontaktpinstecker 101 abschließt und/oder die Gegenseite 104 im Wesentlichen ausbildet. Die Platine 160 ist hierbei im Wesentlichen so groß dimensioniert wie die Gegenseite 104 des Kontaktpinsteckers 100. Die Platine 160 kann als Leiterplatte, z.B. als PCB ausgebildet sein. An der Platine können unterschiedliche elektrische Kontakte des Kontaktpinsteckers 100 miteinander elektrisch kontaktiert sein, z.B. an der Kontaktseite 102 herausragende Kontaktpins und/oder Steckkontakte des Kontaktpinsteckers 100, auf welche nachfolgend näher Bezug genommen wird.

Das Gehäuseelement 110 kann ein oder mehrere Befestigungselemente wie z.B. Noppen 111 aufweisen, die an zumindest einer Seitenfläche, z.B. an der der Kontaktseite 102 gegenüberliegenden Seitenfläche des Kontaktpinsteckers 100, nach außen vom Gehäuseelement 110 abstehen. Die Noppen 111 können als Führung dienen und/oder als Formschlusselement zum Befestigen der Schutzkappe 130 am kappenlosen Kontaktpinstecker 101. Die Schutzkappe 130 kann hierzu komplementäre Schlitze 131 aufweisen (vgl. z.B. Figur 1A), in welche die Noppen 111 eingreifen, wenn die Schutzkappe 130 am Kontaktpinstecker 100 befestigt ist. Die Schutzkappe 130 kann ebenfalls aus einem Flüssigkristallpolymer und/oder einem semi-aromatischen Polyamid ausgebildet sein, insbesondere aus PA9T und/oder PA10T. Alternativ dazu kann die Schutzkappe 130 auch aus PBT ausgebildet sein und beim Verlöten des Kontaktpinsteckers abgenommen werden.

Mit anderen Worten kann anstelle des ganzen Kontaktpinsteckers 100 lediglich der kappenlose Kontaktpinstecker 101 als oberflächenmontiertes Bauelement ausgebildet sein und mit der Leiterplatte verlötet werden. Nachdem der kappenlose Stecker 101 mit der Leiterplatte, welche in den Figuren nicht dargestellt ist, verlötet ist, kann optional die Schutzkappe 130 wieder aufgesetzt werden. Deswegen kann die Schutzkappe 130 auch aus PBT ausgebildet sein.

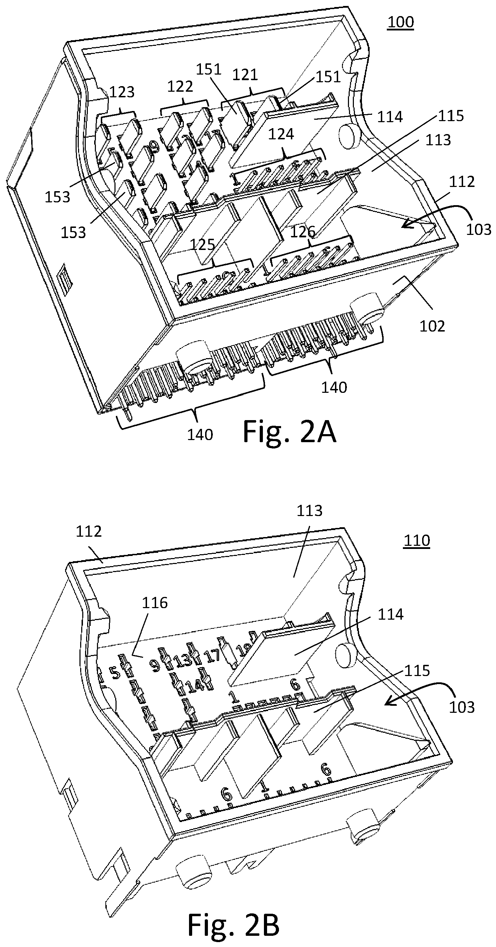

**Figur 2A** zeigt eine perspektivische Darstellung des Kontaktpinsteckers 100, insbesondere auf die Steckseite 103. An der Kontaktseite 102 weist eine Mehrzahl von Kontaktpins 140 aus dem Kontaktpinstecker 100 heraus. Diese Kontaktpins 140 sind hierbei so ausgebildet, dass sie mittels Oberflächenmontage und/der THR-Technologie mit einer in den Figuren nicht dargestellten Leiterplatte verbindbar sind. An der Kontaktseite 102 können weiterhin Abstandshalter wie z.B. Stifte und/oder Noppen ausgebildet sein.

An der Steckseite 103 ist der Kontaktpinstecker 100 im Wesentlichen offen ausgebildet. An dieser Steckseite 103 weist der Kontaktpinstecker eine Einstecköffnung 113 auf. Die Einstecköffnung 113 kann etwa so groß wie die gesamte Steckseite 103 ausgebildet sein. Insbesondere kann die Einstecköffnung 113 so dimensioniert sein, dass sie lateral von der Gehäusewand des Gehäuseelements 110 begrenzt ist.

**Figur 2B** zeigt das Gehäuseelement 110 in derselben Perspektive wie Figur 2A den gesamten Kontaktpinstecker 100 zeigt. Die Einstecköffnung 113 wird im Wesentlichen von dem Gehäuseelement 110 definiert und/oder bereitgestellt. Die Einstecköffnung 113 ist zumindest teilweise, im gezeigten Ausführungsbeispiel vollständig, von der Versteifungsrippe 112 umgeben. Die Versteifungsrippe 112 kann zusätzlich oder optional auch innenseitig ausgebildet sein, also von der Gehäusewand in die Einstecköffnung 113 hineinragend ausgebildet sein. Insbesondere kann die Versteifungsrippe 112 lediglich auf einer Außenseite des Gehäuseelements 110 ausgebildet sein, lediglich auf einer Innenseite, oder sowohl an der Außenseite als auch an der Innenseite des Gehäuseelements 110. Die Versteifungsrippe 112 kann auch abschnittsweise unterschiedlich ausgebildet sein, also z.B. teilweise entlang einer Außenfläche und teilweise entlang einer Innenfläche.

In der Einstecköffnung 113 weist das Gehäuseelement 110 mehrere Strukturelemente auf, durch die Steckplätze definiert werden können. So weist das im Ausführungsbeispiel gezeigte Gehäuseelement 110 eine erste Steckwand 114 sowie eine zweite Steckwand 115 auf, welche den an der Einstecköffnung 113 gebildeten Innenraum in Teilgebiete unterteilt. Durch diese Teilgebiete werden im Inneren der Einstecköffnung 113 mehrere Steckplätze definiert. Diese Steckplätze sind z.B. in Figur 2A gezeigt.

Die erste Steckwand 114 definiert mit einem Teil der Gehäusewand des Gehäuseelements 110 einen ersten Steckplatz 121, an welchem erste Steckkontakte 151 so angeordnet sind, dass sie elektrisch und/oder mechanisch von einem an den ersten Steckplatz 121 aufgesteckten Steckverbinder kontaktiert werden können. An einem zweiten Steckplatz 122 sind eine Mehrzahl zweiter Steckkontakte 152 angeordnet. An einem dritten Steckplatz 123 ist eine Mehrzahl dritter Steckkontakte 152 ausgebildet. Weiterhin können im Kontaktpinstecker 100 vierte Steckkontakte 154 an einem vierten Steckplatz 124, sowie zusätzliche elektrische Kontakte an einem fünften Steckplatz 125 und/oder an einem sechsten Steckplatz 126 ausgebildet sein. An den Steckplätzen 121 bis 126 wird jeweils ein Steckzugang zu elektrischen Kontakten des Kontaktpinsteckers 100 bereitgestellt. Insbesondere wird Steckzugang zu den ersten Steckkontakten 151, den zweiten Steckkontakten 152 und den dritten Steckkontakten 152 bereitgestellt.

Die Steckkontakte 151, 152, 153 und 154 sind als elektrisch leitende Kontakte ausgebildet. Diese Steckkontakte 151, 152, 153 und 154 sind am Gehäuse des Kontaktpinstecker 100 befestigt, insbesondere können sie am Gehäuseelement 110 befestigt sein. Das Gehäuseelement 110 weist dazu eine Steckfläche 116 auf, die z.B. in Figur 2B gezeigt ist. Die Steckfläche 116 ist als eine innere Trennwand ausgebildet, insbesondere als eine Innenwand des Gehäuselements 110 und somit des Kontaktpinsteckers 100. Die Steckfläche 116 kann im Wesentlichen parallel zur Steckseite 103 und parallel zur Gegenseite 104 ausgebildet sein. Die Steckfläche 116 kann zwischen der Steckseite 103 und der Gegenseite 104 ausgebildet sein, insbesondere z.B. im Wesentlichen parallel zur Platine 160. In der Steckfläche 116 können mehrere Stecköffnungen ausgebildet sein, in die beim fertig assemblierten Kontaktpinstecker 100 z.B. die Steckkontakte 151, 152 und/oder 153 eingesteckt sein können. Die Steckfläche 116 kann als Anschlag für in den Figuren nicht gezeigte Steckverbinder ausgebildet sein und/oder als Begrenzung der ersten Steckwand und/oder der zweiten Steckwand 114 und 115 ausgebildet sein.

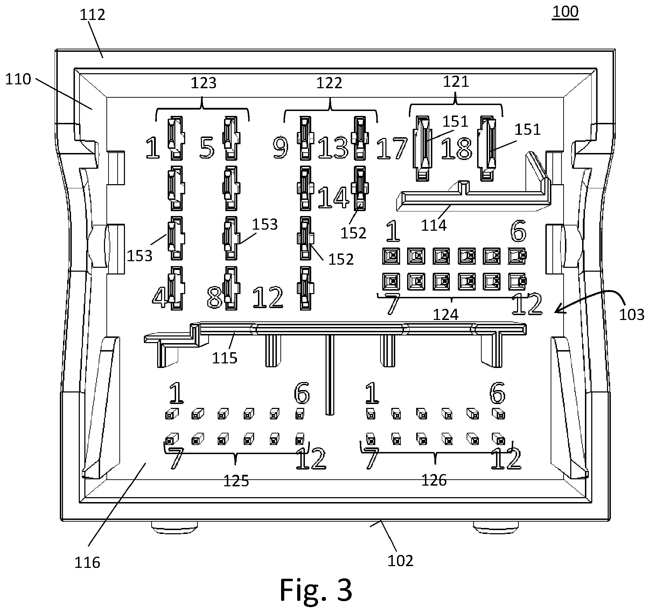

**Figur 3** zeigt eine perspektivische Ansicht auf eine Ausführungsform der Steckfläche 116, und zwar in eine Einsteckrichtung im Wesentlichen senkrecht auf die Steckseite 103 des Kontaktpinsteckers 100. Auf der Steckfläche 116 können Markierungen in Form von Zahlen ausgebildet sein, die als Orientierungshilfe bei der elektrischen Kontaktierung dienen können. So können z.B. die acht dritten Steckkontakte 153 des dritten Steckplatzes 153 mit den Markierungen 1 bis 8 versehen sein. Die sechs zweiten Steckkontakte 152 des zweiten Steckplatzes 122 können mit den Nummerierungen 9 bis 14 versehen sein. Die zwei ersten Steckkontakte 151 des ersten Steckplatzes 121 können mit den Markierungen 17 und 18 versehen sein. Hierbei muss nicht jeder einzelne der Steckkontakte 151 bis 153 mit einer eigenen Markierung versehen sein.

Auch bei dem vierten, fünften und sechsten Steckplatz 124, 125 und 126 können die dort angeordneten elektrischen Kontakte mit Nummern versehen sein, im gezeigten Ausführungsbeispiel sind es jeweils die Nummern 1 bis 12. An den Steckplätzen 121 bis 126 können (in den Figuren nicht gezeigte) Steckverbinder so angeordnet werden, dass sie die entsprechenden Steckkontakte 151 bis 153 bzw. die dort angeordneten anderen elektrischen Kontakte elektrisch und/oder physikalisch kontaktieren. Dabei können sie an den Außenwänden abgestützt sein, insbesondere an den Seitenflächen des Gehäuseelements 110. Weiterhin können die Steckverbinder auch an der ersten Steckwand 114 und/oder an der zweiten Steckwand 115 abgestützt sein.

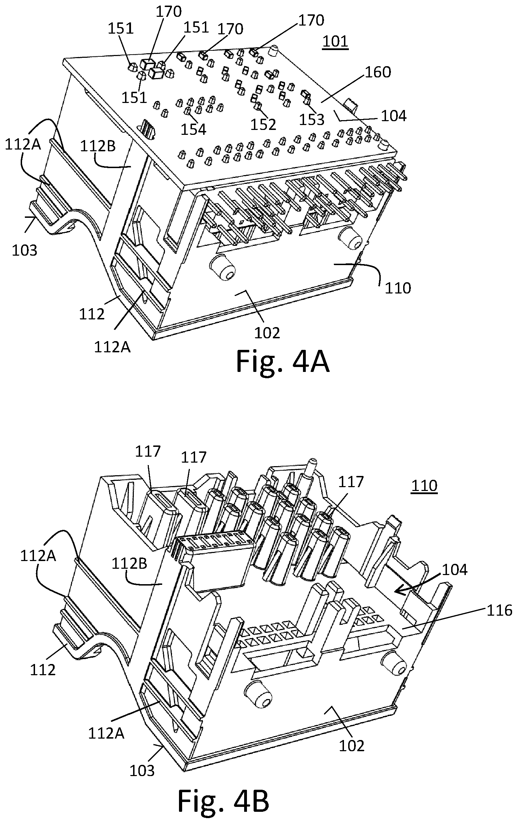

**Die** **Figuren 4A und 4B** zeigen den kappenlosen Kontaktpinstecker 101 (vgl. Figur 4A) und das Gehäuseelement 110 (vgl. Figur 4B) aus derselben Perspektive. Hierbei ist in Figur 4A insbesondere die Kontaktseite 102 und die Gegenseite 104 des kappenlosen Kontaktpinsteckers 101 gezeigt.

Figur 4B zeigt aus derselben Perspektive einen Blick auf die Gegenseite 104 des Gehäuseelements 110. Hierbei ist insbesondere auch ein Blick auf die Gegenseite 104 der Steckfläche 116 gezeigt. Die Steckfläche 116 ist beabstandet von der Platine 160 und somit der Gegenseite 104 ausgebildet. Die Steckfläche 116 ist auch beabstandet von der Steckseite 103 des Kontaktpinsteckers 100 ausgebildet.

Das Gehäuseelement 110 kann neben oder anstatt der umlaufenden Versteifungsrippe 112 zumindest eine kürzere Zusatzrippe 112A und/oder zumindest eine Steckversteifungsrippe 112B aufweisen. Diese zumindest eine Zusatzrippe 112A und/oder Steckversteifungsrippe 11B dient ebenfalls zur Versteifung des Gehäuseelements 110 und kann als eine Verdickung des Gehäuseelements 110 ausgebildet sein.

Dabei kann die zumindest eine Zusatzrippe 112A kann z.B. zumindest abschnittsweise etwa parallel zur Versteifungsrippe 112, also etwa parallel zum Rand der Steckseite 103 ausgebildet sein. Die zumindest eine Steckversteifungsrippe 112B kann etwa parallel zur Steckrichtung ausgebildet sein, und somit etwa senkrecht zum Rand entlang der Steckseite 103 und etwa senkrecht zu den anderen Rippen 112, 112A. Die Steckversteifungsrippe 112B kann an einem Ende ein Befestigungsmittel wie z.B. eine Rastnase aufweisen, welche in eine dazu korrespondierende Aussparung in der Platine 160 eingreifen kann. Dadurch kann eine Verrastung erfolgen, mittels welcher die Platine 160 kraft- und/oder formschlüssig am Gehäuseelement 110 befestigt werden.

Die Zusatzrippe 112A und/oder die Steckversteifungsrippe 112B kann an der nach außen gewandten Seitenfläche des Gehäuseelements 110 ausgebildet sein und die Wandstärke des Gehäuseelements 110 jeweils zumindest verdoppeln.

Durch die zumindest eine Zusatzrippe 112A und/oder die zumindest eine Steckversteifungsrippe 112B wird die Stabilität des Gehäuseelements 110 weiter erhöht, und damit auch die Stabilität des Gehäuses des Kontaktpinsteckers 100 insgesamt. Dies ermöglicht die Verwendung von Materialien für das Gehäuseelement 110, die eine geringere Eigensteifigkeit als z.B. PBT aufweisen, vgl. oben.

In Figur 4B ist weiter gezeigt, dass die Stecköffnungen in der Steckfläche 116 zumindest teilweise als Löcher, insbesondere Durchstecklöcher, ausgebildet sind. So ausgebildet sind z.B. die Stecköffnungen des fünften und sechsten Steckplatzes 125 und 126 (vgl. hierzu auch Figur 3). An den ersten, zweiten und/oder dritten Steckkontakten 151, 152 und/oder 153 (vgl. Figur 3) sind an den Stecköffnungen Führungen ausgebildet, welche aus der der Gegenseite 104 zugewandten Seitenfläche der Steckfläche 116 herausragen. Hierbei sind nur einige weniger der Führungen 117 in Figur 4B mit entsprechenden Bezugszeichen versehen.

Die Führungen 117 können im Wesentlichen als Führungshülsen ausgebildet sein. Die Führungen 117 weisen einen hohlen Kern auf, in den die ersten Steckkontakte 151 angeordnet werden können. Die ersten Steckkontakte 151 sind in der in Figur 4A gezeigten Ansicht von der Platine 160 verdeckt. In Figur 4A ist gezeigt, dass Füße der Steckkontakte 151, 152, 153 und 154 durch die Platine 160 zur Schutzkappe 130 hinausragen.

Zumindest die Steckkontakte 151, 152 und/oder 153 sind im Inneren der Führungen 117 angeordnet und zumindest formschlüssig an dem Gehäuse 110 befestigt.

Weiterhin sind auf der Platine 160 mehrere elektrische Bauteile 170 ausgebildet. Die elektrischen Bauteile 170 dienen zum Filtern und/oder Entstören und/oder Dämpfen von elektrischen Signalen, welche entlang der Steckkontakte 151, 152, und/oder 153 und der Platine 160 zu den Kontaktpins 140 übertragen werden. Die elektrischen Bauteile 170 können auf der der Steckseite 103 abgewandten Seite der Platine 160 an diese Platine 160 angelötet sein.

Die elektrischen Bauteile 170 können als passive und/oder aktive Bauteile ausgebildet sein. Die elektrischen Bauteile 170 sind so ausgebildet, dass sie mittels Reflow-Verfahren auf die Platine 160 gelötet werden können und/oder bereits angelötet sind. Deswegen sind die elektrischen Bauteile 170 entsprechend widerstandsfähig ausgebildet, um die Temperaturen des Reflow-Ofens aushalten zu können, ohne dabei beschädigt zu werden. Hierbei kann jedem der Steckkontakte 151, 152, und/oder 153 genau ein solches elektrisches Bauteil 170 zum Filtern und/oder Entstören zugeordnet sein.

Zusätzlich zu den in den Figuren gezeigten elektrischen Bauteilen 170 können weitere, nicht in den Figuren gezeigte Bauelemente (wie z.B. Transformatoren) auf der Platine 160 angeordnet sein, welche eine galvanische Trennung zwischen den Steckkontakten 151, 152 und/oder 153 und den zugeordneten Kontaktpins 140 bewirken.

Weiterhin kann zumindest ein nicht in den Figuren gezeigtes Bauelement (wie z.B. eine Suppressordiode) auf der Platine 160 angeordnet sein, welches als ein ESV-Schutzmittel einen Schutz gegen elektrostatische Entladungen bereitstellt.

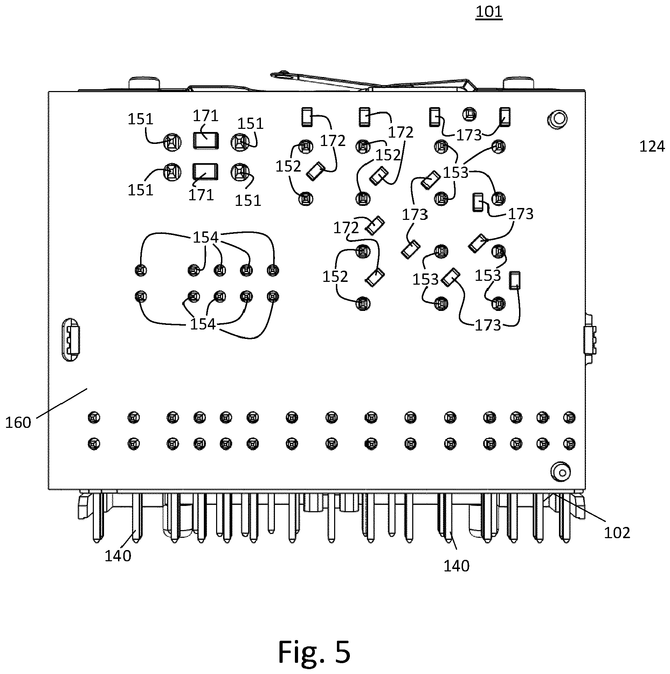

Eine beispielhafte Anordnung der elektrischen Bauteile 170 ist nachfolgend in Fig. 5 näher gezeigt.

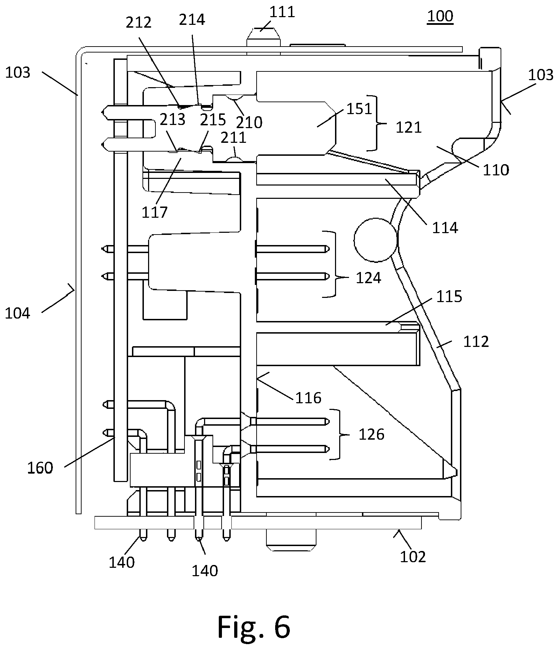

**Fig. 5** zeigt eine Ansicht eines kappenlosen Kontaktpinsteckers 101 gegen die Einsteckrichtung. Die Figur 5 zeigt ein beispielhaftes Layout der Platine 160 des kappenlosen Kontaktpinsteckers 101. Dabei ist gezeigt, dass jedem (Doppel-)Steckkontakt 151 genau ein erster Kondensator 171 zugeordnet ist. Hierbei ist beachtlich, dass jeder der beiden ersten Steckkontakte 151 gabelförmig ausgebildet ist und die Platine 160 als Doppelsteckkontakt an zwei Punkten durchstößt (vgl. Fig. 6).

Die ersten Steckkontakte 151 können zur Übertragung von Gleichstrom ausgebildet sein, also als Leistungssteckkontakte. Deswegen kann jeder der ersten Steckkontakte 151 mit jeweils einem ersten Kondensator 171 mit relativ hoher Kapazität kontaktiert sein, d.h. mit einer Kapazität im µF-Bereich. Somit können die ersten Kondensatoren 171 als elektrische Bauteile 170 (vgl. Fig. 4A) besonders viele unterschiedliche Frequenzen aus den Gleichstromsignalen zur Leistungsübertragung herausfiltern.

Weiterhin kann jedem der zweiten Steckkontakte 152 genau ein zweiter Kondensator 172 und/oder jedem dritten Steckkontakt 153 jeweils ein dritter Kondensator 173 als elektrische Bauteile 170 (vgl. Fig. 4A) zugeordnet sein. Die zweiten und/oder dritten Kondensatoren 172, 173 können mit relativ kleiner Kapazität ausgebildet sein, d.h. mit einer Kapazität im nF-Bereich. Somit können die zweiten und dritten Kondensatoren 172, 173 hochfrequente Störfrequenzen aus den über die Steckkontakte 152, 153 eingekoppelten elektrischen Signale herausfiltern. Die zweiten und dritten Steckkontakte 152, 153 können dabei insbesondere zur Übertragung von Audiosignalen und/oder Radiosignalen ausgebildet sein.

Allgemein kann der Kontaktpinstecker 100 als ein MQS-Steckverbinder für Lautsprecher im Automobil ausgebildet sein, also z.B. als ein Radiostecker.

Da die Kontaktpins 140 mit den Steckkontakten 151, 152, 153 elektrisch über die Platine 160 verbunden sind, sind auch zumindest die so verbundenen Kontaktpins 140 entstört und/oder gedämpft.

Die elektrischen Bauteile 170 können dabei sowohl zur Schirmung beitragen, also auf den Kontaktpinstecker 100, 101 einwirkende Störsignale herausfiltern, als auch in den Signalen enthaltene Störfrequenzen herausfiltern.

Im Folgenden wird näher auf die Befestigung der ersten Steckkontakte 151 des ersten Steckplatzes 121 in den Führungen 117 des Gehäuseelements 110 eingegangen. Die zweiten Steckkontakte 152 und/oder die dritten Steckkontakte 153 können ähnlich in entsprechenden Führungen an dem Gehäuseelement 110 befestigt sein.

**Figur 6** zeigt einen Querschnitt durch den Kontaktpinstecker 100 entlang einer Ebene, welche im Wesentlichen senkrecht zur Kontaktseite 102, zur Steckseite 103 und zur Gegenseite 104 ausgebildet ist. Die Schnittebene ist hier so gewählt, dass sie durch einen der ersten Steckkontakte 151 verläuft.

An der Kontaktseite 102 ragen Kontaktpins 140 aus dem Kontaktpinstecker 100 hervor. Diese Kontaktpins 140 sind so beschaffen, dass sie an einer in den Figuren nicht gezeigten Leiterplatte mit einem Reflow-Weichlötverfahren montiert werden können, also z.B. mit SMT-Technik und/oder mittels THR-Technik. Diese Beschaffenheit zur SMT- und/oder THR-Eignung kann sich in der Materialwahl für die Kontaktpins 140 widerspiegeln, in der Form und/oder in der Länge der Kontaktpins 140. Einige der Kontaktpins 114 können im Wesentlichen L-förmig ausgebildet sein, mit einem ersten L-Schenkel aus der Kontaktseite 102 ragen und mit einem zweiten L-Schenkel z.B. am sechsten Steckplatz 126 kontaktiert werden.

Entlang der Steckseite 103 des Kontaktpinsteckers 100 ist durchgehend die Versteifungsrippe 112 ausgebildet.

An der Gegenseite 104 wird der Kontaktpinstecker 100 von der Schutzkappe 130 begrenzt, welche auf die Noppen 111 des Gehäuseelements 110 geschoben ist.

Der erste Steckkontakt 151 des ersten Steckplatzes 121 weist ein Steckende auf, welches aus der Steckfläche 116 heraussteht in Richtung zum Steckende 103 hin. Dieses Steckende des ersten Steckkontaktes 151 bildet z.B. einen männlichen elektrischen Kontakt für einen in den Figuren nicht gezeigten Steckverbinder aus, welcher an den ersten Steckplatz 121 gesteckt werden kann. Am gegenüberliegenden Ende des ersten Steckkontaktes 151 kann dieser z.B. gabelförmig ausgebildet sein und in zwei Gabelspitzen enden, welche elektrisch mit der Platine 160 kontaktiert sind (z.B. mittels THT-Durchsteckmontage und/oder THR-Montage).

Im dazwischen angeordneten Mittelbereich des ersten Steckkontaktes 151 weist der erste Steckkontakt 151 eine Mehrzahl von Formschlusselementen auf, die in Figur 6 mit den Bezugszeichen 210 bis 215 gekennzeichnet sind. Mit anderen Worten weist der erste Steckkontakt 151 insgesamt sechs verschiedene Formschlusselemente 210 bis 215 auf, mit denen er an dem Gehäuseelement 110 so befestigt ist, dass er im Inneren der Führung 117 formschlüssig mit dem Gehäuseelement 110 verbunden ist. Jedes einzelne der Formschlusselemente 210 bis 215 des ersten Steckkontakts 151 ist an jeweils einem komplementären Formschlusselements des Gehäuseelements 110 befestigt, und zwar in formschlüssiger Wechselwirkung mit diesem.

Hierbei sind zwei der Formschlusselemente, welche in der Figur 6 mit den Bezugszeichen 210 und 211 gekennzeichnet sind, als Aussparungen, Vertiefungen und/oder Nuten ausgebildet, in die entsprechend komplementäre Formschlusselemente des Gehäuseelements 110 eingreifen. Diese komplementären Formschlusselemente des Gehäuseelements 110 können z.B. teilweise kreisförmig ausgebildet sein. Allgemein können diese beiden komplementären Formschlusselemente des Gehäuseelements 110 als Vorsprünge ausgebildet sein, die in die Aussparungen eingreifen, die durch die beiden Formschlusselemente 210 und 211 bereitgestellt werden.

Die übrigen vier Formschlusselemente 212 bis 215 des ersten Steckkontaktes 151 sind als Rastnasen ausgebildet, welche in komplementäre Widerhaken und/oder Aussparungen der Führung 117 eingreifen. Mit anderen Worten ist der erste Steckkontakt 151 im Inneren der Führung 117 an dem Gehäuseelement 110 mittels mehrerer Formschlusselemente befestigt, die sich zumindest teilweise in ihrer Ausbildungsform voneinander unterscheiden. So können die Rastnasen eine unterschiedliche Länge aufweisen, und Eingriffselemente unterschiedliche Wirkradien aufweisen, also unterschiedlich dimensioniert ausgebildet sein. Durch die Befestigung des ersten Steckkontaktes 151 mittels dieser Mehrzahl zumindest teilweise unterschiedlich ausgebildeter Formschlusselemente 210 bis 215 an dem Gehäuseelement 110 wird die Befestigungsstabilität erhöht. Selbst falls eines oder mehrere der Formschlusselemente 210 bis 215 bzw. der dazu komplementären Formschlusselemente des Gehäuseelements 110 brechen sollten, ist der erste Steckkontakt 151 immer noch hinreichend gut über die übrigen Formschlusselemente mit dem Gehäuseelement 110 befestigt. Deswegen können für das Gehäuseelement 110 auch Materialien verwendet werden, welche eine geringere Eigenstabilität und/oder eine höhere Sprödigkeit aufweisen als PBT.

Die beiden ersten Steckkontakt 151 sind vergleichsweise massiv ausgebildet und können zur Leistungsübertragung genutzt werden.

Durch die Ausbildung der zumindest einen Versteifungsrippe 112 am Gehäuseelement 110 wird das Gehäuseelement 110 steifer. Das Gehäuseelement 110 kann alleine das Gehäuse des Kontaktpinsteckers 100 bilden oder als Teil des Gehäuses ausgebildet sein, insbesondere in einem Fall in dem das Gehäuse des Kontaktpinsteckers 100 mehrteilig ausgebildet ist. Durch die Befestigung der elektrischen Kontakte an dem Gehäuseelement 110 mit einer Mehrzahl von Formschlusselementen wird die Widerstandsfähigkeit der besagten elektrischen Kontakte erhöht. Hierbei können insbesondere einige oder alle der Steckkontakte 151 bis 153 mittels einer Mehrzahl von Formschlusselementen an dem Gehäuseelement 110 befestigt sein, da diese beim Ein- und Ausstecken von Steckverbindern eine erhöhte mechanische Belastung erfahren. Die Belastung kann auch während des Betriebs z.B. durch Motorvibrationen auf die Steckkontakte 151 bis 153 erfolgen. Insbesondere können gerade diejenigen der Steckkontakte mit mehreren Formschlusselementen am Gehäuseelement 110 befestigt sein, die im Betrieb erhöhte mechanische Beanspruchung erfahren. Allgemein können an dem Kontaktpinstecker 100 zumindest ein Steckkontakt, bevorzugt zumindest alle Steckkontakte, zumindest eines Steckplatzes derartig mehrfach gesichert formschlüssig am Gehäuseelement 110 befestigt sein.

Z.B. durch die Versteifungsrippe und/oder die Formschlusselemente kann die Stabilität des Kontaktpinsteckers so erhöht werden, dass er im Reflow-Weichlötverfahren montiert werden kann, genauso wie die elektrischen Bauteile 170 zum Filtern und/oder Entstören und/oder Dämpfen der übertragenen Signale.

### Bezugszeichenliste

- 100: Kontaktpinstecker
- 101: kappenloser Kontaktpinstecker
- 102: Kontaktseite
- 103: Steckseite
- 104: Gegenseite
- 110: Gehäuseelement
- 111: Noppe
- 112: Versteifungsrippe
- 112A: Zusatzrippe
- 112B: Steckversteifungsrippe
- 113: Einstecköffnung
- 114: erste Steckwand
- 115: zweite Steckwand
- 116: Steckfläche
- 117: Führung
- 121: erster Steckplatz
- 122: zweiter Steckplatz
- 123: dritter Steckplatz
- 124: vierter Steckplatz
- 125: fünfter Steckplatz
- 126: sechster Steckplatz
- 130: Schutzkappe
- 131: Schlitz
- 140: Kontaktpins
- 151: erster Steckkontakt
- 152: zweiter Steckkontakt
- 153: dritter Steckkontakt
- 154: vierter Steckkontakt
- 160: Platine
- 170: elektrisches Bauteil
- 171: erster Kondensator
- 172: zweiter Kondensator
- 173: dritter Kondensator
- 210: Formschlusselement
- 211: Formschlusselement
- 212: Formschlusselement
- 213: Formschlusselement
- 214: Formschlusselement
- 215: Formschlusselement

## Patentansprüche

1. Kontaktpinstecker (100; 101) mit
- einem Gehäuse (110, 130) und
- einer Mehrzahl von Kontaktpins (140), welche an dem Gehäuse (110, 130) so ausgebildet und angeordnet sind, dass sie zum Kontaktieren und Verlöten mit einer Leiterplatte von dem Gehäuse (110, 130) abstehen,
wobei
- zumindest einige der Kontaktpins (140) elektrisch gekoppelt sind an jeweils zugehörige elektrische Bauteile (170) zum Filtern und/oder Entstören von elektrischen Signalen, welche entlang der jeweils zugehörigen Kontaktpins (140) übertragen werden und
- diese elektrischen Bauteile (170) zum Filtern und/oder Entstören mittels Reflow-Verfahren auf den Kontaktpinstecker (100; 101) aufgelötet und/oder auflötbar sind.

2. Kontaktpinstecker nach Anspruch 1, wobei die elektrischen Bauteile (170) auf eine Platine (160) des Kontaktpinsteckers (100; 101) aufgelötet und/oder auflötbar sind, welche auch die Kontaktpins (140) elektrisch kontaktieren.

3. Kontaktpinstecker nach Anspruch 2, mit elektrischen Steckkontakten (151, 152, 153), welche mit den Kontaktpins (140) über die Platine (160) elektrisch kontaktiert sind, wobei die elektrischen Bauteile (170) jeweils benachbart zu den elektrischen Steckkontakten (151, 152, 153) auf der Platine angeordnet sind.

4. Kontaktpinstecker nach einem der vorangehenden Ansprüche, wobei die elektrischen Bauteile (170) einen Kondensator (171, 172, 173) aufweisen und/oder als Kondensatoren (171, 172, 173) ausgebildet sind.

5. Kontaktpinstecker nach Anspruch 4, wobei zur Signalübertragung ausgebildete Kontaktpins (140) mit elektrischen Bauteilen (170) kontaktiert sind, welche zumindest einen Kondensator (172, 173) im Nanofarad-Bereich aufweisen, welcher zum Dämpfen hoher Signalfrequenzen ausgebildet ist.

6. Kontaktpinstecker nach Anspruch 4 oder 5, wobei zur Stromübertragung ausgebildete Kontaktpins (140) mit elektrischen Bauteilen (170) kontaktiert sind, welche zumindest einen Kondensator (171) im Mikrofarad-Bereich aufweisen, welcher zum Herausfiltern von Störsignalen aus einer Gleichstromversorgung ausgebildet ist.

7. Kontaktpinstecker nach einem der vorangehenden Ansprüche, wobei der Kontaktpinstecker (100; 101) elektrische Steckkontakte (151, 152, 153) aufweist und die elektrischen Signale, welche von den elektrischen Bauteilen (170) gefiltert und/oder entstört werden, zwischen den elektrischen Steckkontakten (151, 152, 153) und den Kontaktpins (140) übertragen werden.

8. Kontaktpinstecker nach Anspruch 7, wobei zumindest ein elektrisches Bauelement eine galvanische Trennung zwischen zumindest einem der Kontaktpinstecker (140) und dem zugeordneten elektrischen Steckkontakt (151; 152; 153) bereitstellt.

9. Kontaktpinstecker nach einem der vorangehenden Ansprüche, wobei der Kontaktpinstecker (100; 101) zumindest ein elektrisches Bauelement aufweist, welches einen Schutz gegen elektrostatische Entladungen bereitstellt.

10. Kontaktpinstecker nach einem der vorangehenden Ansprüche, wobei der Kontaktpinstecker (100; 101) so ausgebildet ist, dass er über die Kontaktpins (140) mittels Oberflächenmontage und/oder mittels Through-Hole-Reflow-Technologie an der Leiterplatte befestigbar ist.

11. Kontaktpinstecker nach einem der vorangehenden Ansprüche, wobei der Kontaktpinstecker (100; 101) als ein Automobilstecker und/oder als ein Micro-Quadlock System-Stecker und/oder als ein Automobil-Audiostecker ausgebildet ist.

12. Kontaktpinstecker nach einem der vorangehenden Ansprüche, wobei das Gehäuse (110, 130) zumindest teilweise aus Flüssigkristallpolymer und/oder aus semi-aromatischen Polyamiden ausgebildet ist.

13. Kontaktpinstecker nach einem der vorangehenden Ansprüche, wobei das Gehäuse (110, 130) zumindest eine Versteifungsrippe (112) aufweist.

14. Kontaktpinsteckersystem mit einem Kontaktpinstecker (100; 101) nach einem der vorangegangenen Ansprüche und einer Leiterplatte, wobei
- die elektrischen Bauteile (170) zum Filtern und/oder Entstören mittels Reflow-Verfahren auf den Kontaktpinstecker (100; 101) aufgelötet sind und
- der Kontaktpinstecker (100; 101) über seine Kontaktpins (140) mittels Oberflächenmontage und/oder mittels Through-Hole-ReflowTechnologie an der Leiterplatte befestigt ist.

15. Verfahren zum Herstellen eines Kontaktpinsteckers (100; 101) mit den Schritten:
- Bereitstellen eines Gehäuses (110, 130) des Kontaktpinsteckers (100; 101);
- Bereitstellen einer Mehrzahl von Kontaktpins (140) des Kontaktpinsteckers (100; 101), welche an dem Gehäuse (110, 130) so ausgebildet und angeordnet werden, dass sie zum Kontaktieren und Verlöten mit einer Leiterplatte von dem Gehäuse (110, 130) abstehen;
- elektrisches Koppeln zumindest einiger der Kontaktpins (140) an jeweils zugehörige elektrische Bauteile (170) zum Filtern und/oder Entstören von elektrischen Signalen, welche entlang der jeweils zugehörigen Kontaktpins (140) übertragen werden und
- Auflöten dieser elektrischen Bauteile (170) zum Filtern und/oder Entstören mittels Reflow-Verfahren auf den Kontaktpinstecker (100; 101).
